(19) Europäisches Patentamt
European Patent Office
Office européen des brevets

(11) **EP 2 830 899 B1**

(12) **FASCICULE DE BREVET EUROPEEN**

(45) Date de publication et mention de la délivrance du brevet:
**08.04.2020 Bulletin 2020/15**

(21) Numéro de dépôt: **13711400.5**

(22) Date de dépôt: **22.03.2013**

(51) Int Cl.:
**B60J 3/04** *(2006.01)*

(86) Numéro de dépôt international:
**PCT/EP2013/056041**

(87) Numéro de publication internationale:
**WO 2013/144002 (03.10.2013 Gazette 2013/40)**

(54) **PROCÉDÉ ET DISPOSITIF D'AIDE À LA CONDUITE DIURNE DES VÉHICULES AUTOMOBILES**

VERFAHREN UND VORRICHTUNG ZUR UNTERSTÜZUNG DES FAHRENS VON FAHRZEUGEN MIT TAGESLICHT

METHOD AND DEVICE FOR THE SUPPORT OF DAYLIGHT DRIVING OF VEHICLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.03.2012 FR 1252674**

(43) Date de publication de la demande:
**04.02.2015 Bulletin 2015/06**

(73) Titulaire: **Valeo Vision**
**93012 Bobigny Cedex (FR)**

(72) Inventeur: **FLEURY, Benoist**
**94300 Vincennes (FR)**

(56) Documents cités:
**WO-A1-96/20846     US-A- 4 286 308**

## Description

*Domaine de l'invention*

La présente invention concerne les procédés et les dispositifs destinés à apporter une aide à la conduite des véhicules automobiles, particulièrement en conduite de jour lorsque la luminosité extérieure est variable dans des proportions importantes, par exemple par temps ensoleillé, lorsque divers évènements peuvent alternativement éclairer fortement la scène de route et l'assombrir.

*État de la technique*

Diverses solutions ont été expérimentées pour pallier à cette situation.

Une solution classique consiste pour le conducteur à porter des lunettes de soleil, pour éviter d'être ébloui par le soleil et mieux distinguer les détails de la scène de route devant son véhicule.

L'inconvénient de ces lunettes de soleil est que le conducteur doit les retirer à chaque fois que le véhicule passe dans une zone ombragée ou dans un tunnel, ou quand le soleil est caché par des nuages épais. En effet, l'atténuation apportée par les lunettes de soleil, par nature constante, produit également ses effets en l'absence de gêne par le soleil, de sorte que le conducteur a plus de difficultés à appréhender les détails de la scène de route.

Une amélioration à ces lunettes de soleil classiques a consisté à prévoir des verres de lunette photochromiques, sensibles à la quantité de lumière ambiante. Ces verres ont la particularité de se teindre en fonction de la quantité de rayonnements ultraviolets à laquelle ils sont soumis. L'inconvénient bien connu de ces verres photochromiques est qu'ils ne retrouvent leur état de plus grande clarté, en l'absence de rayonnements ultraviolets, que très graduellement, leur temps de retour à l'état clair étant beaucoup plus important que le temps nécessaire pour se teinter.

A cet inconvénient s'en ajoute un autre : du fait qu'ils ne réagissent qu'à la présence des rayons ultraviolets, leur utilisation pour la conduite des automobiles n'apporte généralement aucun avantage, puisque les pare-brise de la plupart des véhicules modernes bloquent la transmission de ces rayons ultraviolets. Les verres photochromiques sont donc inefficaces pour éviter l'éblouissement des conducteurs de véhicules automobiles par des variations importantes de luminosité extérieure.

D'autres solutions plus élaborées que de simples lunettes de soleil, même photochromiques, ont été proposées. On connaît par exemple du document US 3 961 181 un écran pour conducteurs de véhicules, qui protège séparément mais simultanément les deux yeux contre l'effet d'éblouissement diurne dû à la lumière du soleil ou nocturne dû à des projecteurs de véhicules croisés. L'écran comporte une série de cellules verticales juxtaposées et contiguës, qui peuvent être commandées électriquement, par exemple des cristaux liquides, ces cellules étant transparentes en l'absence de tension appliquée, et s'obscurcissant en fonction de la tension appliquée. Une rangée de capteurs photosensibles, dont la résistance électrique croît avec la luminosité est associée à la série de cellules. Des caches sont disposés devant les capteurs pour créer des ombres sur ces capteurs. Des moyens de contrôle électrique sont interposés entre les capteurs et les cellules de l'écran pour commander le facteur de transmission des cellules en fonction des signaux reçus des différents capteurs.

Une telle structure est relativement complexe à réaliser et à ajuster, le but étant de n'obscurcir que les cellules situées entre la source d'éblouissement et les yeux du conducteur.

On connaît également de US 4 848 890 des lunettes, dont les verres sont constitués d'une matrice de cellules à cristaux liquides, et dont la monture est pourvue d'un capteur photosensible directionnel. En fonction de la direction d'où viennent les rayons du soleil, des cellules sont commutées dans un état opaque pour éviter au porteur de lunettes d'être ébloui par le soleil. L'inconvénient majeur d'une telle disposition tient au fait qu'une grande partie des verres de lunette est assombrie, pratiquement un quart de la surface de chaque verre, ce qui implique une réduction du champ visuel incompatible avec la conduite d'un véhicule automobile.

On connaît encore de EP 0 498 143 un écran actif anti-éblouissement pour conducteur de véhicule automobile. Cet écran, qui est fixé sur la pare-brise du véhicule ou qui peut prendre la forme de verres de lunettes, comporte un capteur de la luminosité ambiante, un circuit de mesure et de comparaison de la valeur mesurée avec une valeur de seuil commande l'état de transparence des cristaux liquides constituant les verres de lunettes. Ces derniers sont totalement transparents en l'absence de signal de mesure. Une telle disposition a pour inconvénient de fonctionner en mode binaire, en tout ou rien, les verres étant dans un état de transparence maximale ou minimale si la luminosité est inférieure ou supérieure à un seuil prédéterminé.

Le document US 4 286 308 divulgue par ailleurs un dispositif d'anti-éblouissement pour la conduite nocturne, comprenant un écran à transmission variable situé devant le conducteur, des projecteurs capables d'être commutés rapidement d'un état allumé à un état éteint, un capteur de la luminosité de la scène de route devant le véhicule et une centrale de commande. Quand le niveau de luminosité extérieure est sous une limite prédéterminée, l'écran à transmission variable est dans son état de transmission maximale.

A l'approche de véhicules circulant en sens inverse, en fonction de la luminosité détectée par le capteur, la centrale commande automatiquement le rapport transmission/absorption de l'écran à transmission variable pour accroître la densité apparente de cet écran.

Quand la luminosité extérieure dépasse une valeur prédéterminée, les périodes pendant lesquelles l'écran à transmission variable est opaque sont à leur durée maximale de sorte que l'écran ne soit transmissif que lorsque les projecteurs sont allumés, procurant ainsi un maximum de réduction de l'éblouissement.

Le document WO 96/20846 divulgue un procédé et un dispositif d'atténuation de la lumière des projecteurs des véhicules croisés, comprenant l'émission d'impulsions lumineuses par les projecteurs du véhicule, et la commande de la transparence de filtres devant les yeux du conducteur en synchronisme avec les impulsions lumineuses émises par les projecteurs du véhicule, la transparence des filtres étant maximale pendant une durée supérieure à celle des impulsions lumineuses. De la sorte, la luminosité de projecteurs adverses est réduite.

Ces deux derniers documents présentent des systèmes encombrants et d'utilisation malaisée, dont le fonctionnement est relativement lent avec des temps de réponse relativement importants, et dans lesquels la transparence des filtres ou des écrans utilisés est toujours inférieure à 50 %, c'est-à-dire que ces systèmes, utilisant des cristaux liquides, induisent une diminution de l'intensité lumineuse perçue, même lorsqu'ils présentent leur transmission maximale.

*Exposé de l'invention*

La présente invention se place dans ce contexte et elle a pour but d'apporter une aide à la conduite de jour d'un véhicule automobile, en procurant au conducteur de ce véhicule un procédé pour

- atténuer la luminosité d'une scène de route fortement ensoleillée, et éviter l'éblouissement du conducteur, et
- permettre une vision de la scène de route avec une atténuation progressivement décroissante en fonction de la diminution de la luminosité de la scène de route, jusqu'à une transparence maximale pour une luminosité faible de la scène de route,
- la variation de l'atténuation s'effectuant automatiquement,
- sans par ailleurs entraver les mouvements du conducteur ou restreindre son champ de vision.

Dans ce but, la présente invention a pour objet un procédé d'aide à la conduite diurne d'un véhicule automobile, comportant les étapes consistant à :

- disposer au moins un écran à transmission variable entre le conducteur du véhicule et la scène de route en avant du véhicule,
- mesurer à l'aide d'au moins un capteur la luminosité de la scène de route en avant du véhicule,
- traiter le signal de la mesure de luminosité pour le transformer en un signal de commande du coefficient de transmission de l'écran à transmission variable.

Selon l'invention, le procédé comporte l'étape supplémentaire de transmettre le signal de commande par des ondes de télécommande à un récepteur équipant l'écran à transmission variable pour moduler le coefficient de transmission de l'écran à transmission variable n fonction de la luminosité mesurée par le capteur.

Selon d'autres caractéristiques de l'invention, considérées séparément ou en combinaison :

- le coefficient de transmission de l'écran à transmission variable est modulé en fonction de la luminosité mesurée par le capteur, entre une valeur maximale pour une transparence maximale pendant une première durée et une valeur minimale pour une transparence minimale pendant une deuxième durée ;
- la première durée à coefficient de transmission maximale et la deuxième durée à coefficient de transmission minimale se succèdent selon un cycle de modulation de largeur d'impulsions PWM ;
- le coefficient de transmission de l'écran à transmission variable est fonction de la mesure de la luminosité de la scène de route en avant du véhicule.

L'invention a également pour objet un dispositif d'aide à la conduite diurne d'un véhicule automobile, comportant :

- un écran à transmission variable entre le conducteur du véhicule et la scène de route en avant du véhicule,
- un capteur de mesure de la luminosité de la scène de route en avant du véhicule,
- un dispositif de traitement du signal de la mesure de luminosité pour le transformer en un signal de commande du coefficient de transmission de l'écran à transmission variable.

Selon l'invention, une centrale de commande reçoit le signal de commande et le transmet par ondes de télécommande à un récepteur équipant l'écran à transmission variable pour en piloter le coefficient de transmission.

Selon d'autres caractéristiques de l'invention, considérées séparément ou en combinaison :

- le coefficient de transmission de l'écran à transmission variable est modulé, en fonction de la luminosité mesurée par le capteur, entre une valeur maximale pour une transparence maximale pendant une première durée et une valeur minimale pour une transparence minimale pendant une deuxième durée ;
- le coefficient de transmission de l'écran à transmission variable est modulé selon un cycle de modulation de largeur d'impulsions PWM ;
- le rapport cyclique du cycle de modulation de largeur d'impulsions PWM est fonction de la mesure de la luminosité de la scène de route en avant du véhicule ;

- l'écran à transmission variable entre le conducteur du véhicule et la scène de route en avant du véhicule est constitué par :
- le pare-brise du véhicule,
- un écran disposé entre le pare-brise du véhicule et le conducteur du véhicule, ou
- des lunettes portées par le conducteur du véhicule.

Selon l'invention,

- la commande du coefficient de transmission de l'écran à transmission variable en fonction de la luminosité mesurée est effectuée selon un protocole de communication sans fil ;
- la commande du coefficient de transmission de l'écran à transmission variable est effectuée par une centrale de commande, recevant les signaux d'un capteur de mesure de la luminosité de la scène de route en avant du véhicule, et les signaux d'un capteur de mesure de la quantité de lumière transmise par l'écran à transmission variable.

Selon d'autres caractéristiques de l'invention, le rapport cyclique du cycle de modulation de largeur d'impulsions PWM est fonction de la mesure de la luminosité de la scène de route en avant du véhicule.

L'invention a également pour objet un écran à transmission variable apte à être disposé entre le conducteur d'un véhicule automobile et la scène de route en avant du véhicule.

Selon l'invention, le coefficient de transmission de l'écran est variable selon un mode de Modulation de Largeur d'Impulsions PWM entre une valeur maximale et une valeur minimale, le coefficient de transmission de l'écran à transmission variable étant piloté par une centrale de commande selon un protocole de communication sans fil, par des ondes de télécommande émises par un émetteur de la centrale de commande et reçues par un récepteur.

*Brève description des Figures*

D'autres buts, caractéristiques et avantages de la présente invention ressortiront clairement de la description qui va maintenant être faite d'un exemple de réalisation donné à titre non limitatif en référence aux dessins annexés sur lesquels :

- La Figure 1 représente schématiquement en coupe partielle un véhicule équipé d'un dispositif selon la présente invention ;
- La Figure 2 représente schématiquement un diagramme de fonctionnement du dispositif selon la présente invention, et
- Les Figures 3A à 3C représentent des diagrammes de l'évolution temporelle des différents signaux utilisés dans les circuits de la présente invention.

*Description détaillée de modes de réalisation de l'invention*

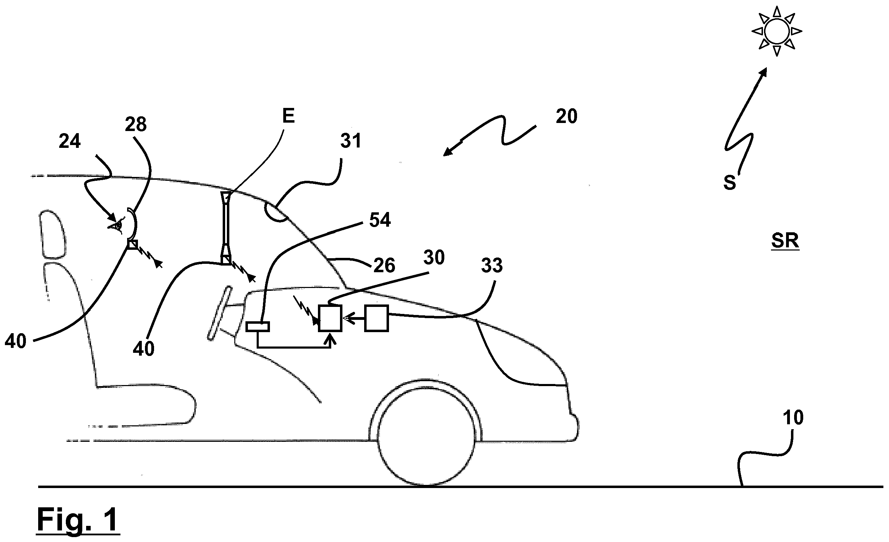

On a représenté sur la Figure 1 une coupe partielle d'un véhicule, désigné dans son ensemble par la référence 20, circulant sur une route 10 en étant piloté par un conducteur 24, symbolisé par un œil.

On voit sur cette Figure 1 que par temps ensoleillé, notamment en fin de journée lorsque la hauteur du soleil S sur l'horizon est faible, la scène de route SR en avant du véhicule 20 est fortement éclairée, et que le conducteur risque non seulement d'être ébloui, mais peut aussi ne pas distinguer des détails de cette scène de route importants pour sa sécurité, par exemple des panneaux de signalisation avertissant de la proximité d'un danger, ou l'état de la chaussée sur laquelle il circule.

L'invention prévoit donc de disposer entre le conducteur 24 et la scène de route SR un écran à transmission variable pour moduler la quantité de lumière atteignant l'œil du conducteur 24.

Selon les modes de réalisation de l'invention, l'écran à transmission variable peut être constitué :

- d'un écran E proprement dit, placé entre le conducteur 24 et le pare-brise 26, par exemple rabattable à la façon d'un pare-soleil,
- du pare-brise 26 lui-même, ou
- d'une paire de lunettes 28, portées par le conducteur, à l'instar de lunettes de soleil ou de lunettes correctrices, un seul verre de lunette 28 ayant été représenté sur la Figure 1.

Ces trois modes de réalisation ont été représentés simultanément sur la Figure 1, pour la commodité de l'exposé. Ce ne sont cependant que des variantes de réalisation de l'invention, chacune d'entre elles tendant à obtenir le même résultat.

Dans la suite de la description, le terme « écran à transmission variable » sera utilisé pour désigner indifféremment :

- l'écran E, qu'il soit fixe ou de type pare-soleil rabattable,
- le pare-brise 26 ou
- une paire de lunettes 28.

L'écran à transmission variable E est conçu pour avoir un temps de réponse très faible, et permettre une variation rapide de son coefficient de transmission.

Les cristaux liquides permettent d'obtenir de tels écrans à réaction rapide. D'autres technologies permettent également d'obtenir les mêmes résultats, par exemple les systèmes microélectromécaniques, par exemple du type décrit dans le document US 7 684 105.

Si l'écran à transmission variable est fixe, comme par exemple le pare-brise 26, il pourra être relié directement au faisceau électrique du véhicule pour assurer son alimentation électrique (par une liaison non représentée).

Si l'écran à transmission variable est mobile, comme par exemple l'écran E de type pare-soleil ou la paire de lunettes 28, il pourra comprendre son alimentation électrique autonome propre (non représentée). En effet, la commande de l'état de transparence, ou du coefficient de transmission, d'un écran à cristaux liquides ou d'un système microélectromécanique ne requiert qu'une puissance électrique minime, de sorte que des batteries au format des piles boutons sont amplement suffisantes pour assurer un fonctionnement correct de l'écran à cristaux liquides ou du système microélectromécanique pendant un temps appréciable, surtout s'agissant des lunettes 28.

Le terme « microélectromécanique » est utilisé dans la présente description pour désigner en français le concept connu de l'acronyme anglo-saxon MEMS (pour « MicroElectroMechanical System »).

Pour la commande du coefficient de transmission de l'écran à transmission variable, l'invention prévoit d'utiliser un capteur photosensible 31 de mesure de la luminosité de la scène de route en avant du véhicule.

Avantageusement, le capteur photosensible 31 est situé sur la face intérieure du pare-brise 26, au niveau du rétroviseur intérieur (non représenté), c'est-à-dire au milieu de la partie supérieure du pare-brise 26. Cette position permet de recueillir une information particulièrement représentative de la luminosité extérieure au véhicule, issue de la scène de route SR. Avantageusement encore, les signaux de mesure du capteur photosensible 31 pourront par ailleurs être utilisés pour commander l'allumage des feux de croisement lorsque la luminosité de la scène de route devient inférieure à un seuil prédéterminé, comme sur la plupart des véhicules modernes.

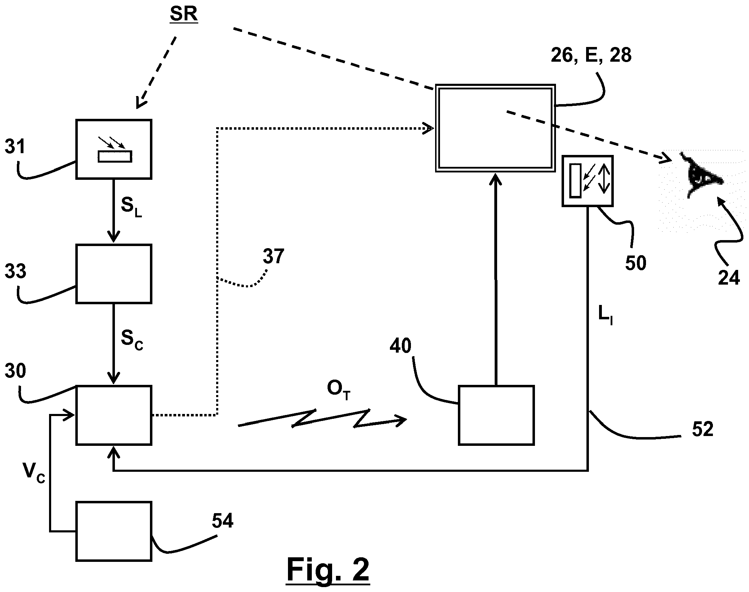

Comme on l'a représenté plus en détail sur la Figure 2, le signal de sortie $S_L$ de ce capteur photosensible 31 est reçu et traité par un circuit 33 apte à transformer ce signal de sortie $S_L$ en un signal de commande $S_C$ du coefficient de transmission de l'écran à transmission variable, ce signal $S_C$ étant à son tour reçu par une centrale de commande 30 du coefficient de transmission de l'écran à transmission variable.

La centrale de commande 30 peut comprendre un émetteur par exemple d'ondes radio, infrarouges ou ultrasonores selon un protocole de communication sans fil, par exemple selon les normes Bluetooth ou Wi-Fi (marques déposées). Ces ondes seront appelées dans la suite de la description « ondes de télécommande » OT. L'écran à transmission variable E ou les lunettes 28 sont pourvues d'un récepteur 40 de ces mêmes ondes de télécommande $O_T$.

Conformément à la présente invention, la modulation du coefficient de transmission de l'écran à transmission variable s'effectue en temps réel, en fonction de la luminosité de la scène de route SR mesurée par le capteur photosensible 31.

A cet effet, en réponse au signal de sortie $S_L$ du capteur photosensible 31, représentatif de la luminosité de la scène de route SR devant le véhicule 20, le circuit 33 génère un signal de commande $S_C$, fonction du signal $S_L$. Le signal de commande $S_C$ est alors transmis, soit directement par la centrale de commande 30 et la liaison filaire 37, soit par l'émetteur de la centrale de commande 30, les ondes $O_T$ et le récepteur 40, à l'écran à transmission variable.

Le coefficient de transmission de l'écran à transmission variable va ainsi être modulé en fonction du signal $S_C$ reçu, c'est-à-dire en fonction de la luminosité mesurée par le capteur 31, selon un principe bien connu.

Ainsi, plus la luminosité mesurée par le capteur 31 sera élevée, plus le signal $S_L$ sera intense, et plus le coefficient de transmission de l'écran à transmission variable sera faible, ou, en d'autres termes, plus la transmission par l'écran à transmission variable sera faible.

On a donc bien réalisé un écran à transmission variable, dont le coefficient de transmission est ajusté en temps réel en fonction de la luminosité de la scène de route observée par le conducteur : plus la luminosité est élevée, plus l'écran à transmission variable est obscurci, et inversement.

Le conducteur du véhicule circulant dans un environnement dans lequel la luminosité est fortement variable pourra ainsi observer la scène de route devant son véhicule à travers l'écran à transmission variable qui vient d'être décrit, cet écran

- atténuant la luminosité d'une scène de route fortement ensoleillée, et évitant l'éblouissement du conducteur,
- permettant une vision de la scène de route avec une atténuation progressivement décroissante en fonction de la diminution de la luminosité de la scène de route, jusqu'à une transparence maximale pour une luminosité faible de la scène de route,
- la variation de l'atténuation s'effectuant automatiquement.

De manière à obtenir le coefficient de transmission qui procure exactement l'obscurcissement désiré, il est possible d'inclure dans la commande de ce coefficient une boucle de réaction, comme on l'a représenté sur la Figure 2.

Dans une telle boucle, un capteur oculaire 50 mesure la quantité de lumière réfléchie par la cornée de l'œil 24 du conducteur. Par hypothèse, la lumière reçue par l'œil a déjà traversé l'écran à transmission variable.

Dans le cas où l'écran à transmission variable est constitué par le pare-brise 26 ou d'un écran E de type pare-soleil, le capteur 50 pourra par exemple être constitué d'une caméra vidéo miniature, disposée à proximité du capteur 31, et braquée sur le visage du conducteur. Le traitement de l'image fournie par ce capteur 50 permet d'isoler les yeux du conducteur. De tels capteurs sont déjà connus pour détecter la somnolence éventuelle du conducteur et l'avertir. Ces capteurs peuvent également mesurer la quantité de lumière réfléchie par la cornée de l'œil 24 du conducteur, et donc d'en déduire la quantité de lumière transmise par l'écran à transmission variable.

Dans le cas où l'écran à transmission variable est constitué de lunettes 28 portées par le conducteur, le capteur 50 pourra être intégré dans la monture de ces lunettes.

La mesure par le capteur 50 de la quantité de lumière réfléchie par la cornée de l'œil 24 constitue une mesure de la quantité de lumière atteignant cet œil 24, éventuellement après un calibrage ou un étalonnage préliminaire, et constitue donc une mesure indirecte de la quantité de lumière transmise par l'écran à transmission variable.

Cette mesure $L_I$ de lumière transmise par l'écran à transmission variable et incidente sur l'œil 24 est transmise par une liaison 52 à la centrale de commande 30.

La liaison 52 peut être filaire dans le cas où l'écran à transmission variable est constitué par le pare-brise 26 ou par l'écran mobile E. Si l'écran à transmission variable est constitué par des lunettes 28, la liaison 52 sera avantageusement constituée par une liaison sans fil, par exemple à l'aide d'ondes radio, infrarouges ou ultrasonores selon un protocole de communication sans fil.

Il en résulte donc que la centrale de commande 30 dispose à la fois :

- de la mesure directe de la luminosité de la scène de route SR, grâce au capteur 31, et
- de la luminosité de la scène de route, atténuée par l'écran à transmission variable, grâce au capteur 50.

La centrale de commande 30 contient un comparateur, qui compare la valeur mesurée $L_I$ de la lumière incidente sur l'œil 24, après passage par l'écran à transmission variable, avec une valeur de consigne $V_C$, contenue dans une mémoire 54. En fonction de la différence entre la valeur de consigne $V_C$ et la valeur mesurée $L_I$, et en fonction du signal $S_C$, lui-même fonction de la valeur de la luminosité extérieure au véhicule, la centrale de commande 30 ajuste en permanence le signal de commande transmis par la liaison filaire 37 ou par les ondes $O_T$ pour que la valeur mesurée $L_I$ soit égale à la valeur de consigne $V_C$.

Cette valeur de consigne $V_C$ pourra être figée en mémoire 54, ou, de préférence ajustable, par exemple en étant réglée au tableau de bord du véhicule 20, comme on l'a représenté sur la Figure 1.

Ainsi, le conducteur 24 pourra régler le degré d'assombrissement à toute valeur désirée pour observer dans les meilleurs conditions possibles la scène de route devant son véhicule, la quantité de lumière atteignant son œil restant constante, et égale à une valeur prédéterminée, telle qu'elle a été assignée par le conducteur à la mémoire 54.

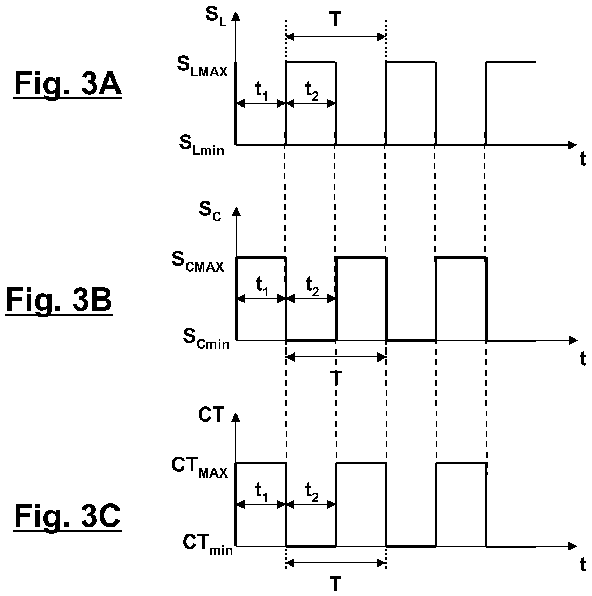

Selon un mode de réalisation préféré de l'invention, on pourra prévoir que la transmission des signaux soit effectuée non plus de manière continue et analogique, comme on l'a décrit plus haut, mais de manière numérique, c'est-à-dire de manière alternative, de préférence en modulation de largeur d'impulsions PWM (pour l'expression anglo-saxonne « Pulse Width Modulation »), à une fréquence prédéterminée, conformément aux diagrammes de la Figure 3.

Selon ce mode de réalisation, le capteur photosensible 31 émet un signal analogique dont la valeur est fonction de l'intensité lumineuse qu'il reçoit de la scène de route devant le véhicule. Le capteur 31 est associé à un circuit qui transforme ce signal analogique en un signal numérique $S_L$ codé en PWM.

Comme on le voit sur la Figure 3A, ce signal $S_L$ varie entre une valeur $S_{Lmin}$ pendant une durée (t1) et une valeur $S_{LMAX}$ pendant une durée $t_2$, la somme des durées t1 et $t_2$ définissant la période T du signal alternatif $S_L$.

On rappelle que le rapport cyclique $\beta$ du signal $S_L$ est déterminé par le ratio entre la durée $t_2$ pendant laquelle le signal est maximal, et la durée T de la période, et varie donc de 0 à 100 % :

$$\beta = \frac{t_2}{T}$$

Le rapport cyclique $\beta$ apparaît ainsi comme une fonction directe de l'intensité lumineuse reçue par le capteur 31

Ce signal $S_L$ est reçu par le circuit 33, qui le transforme en un signal de commande $S_C$ représenté sur la Figure 3B.

Le signal $S_C$ varie entre une valeur maximale $S_{CMAX}$ pendant la durée t1 et une valeur minimale $S_{Cmin}$ pendant la durée $t_2$, de même période T = $t_1$ + $t_2$ que le signal $S_L$ et de rapport cyclique $\alpha$ tel que

$$\alpha = \frac{t_1}{T} = 1 - \beta$$

En résumé, en réponse au signal $S_L$ fourni par le capteur photosensible 31, fonction de la valeur de la luminosité de la scène de route SR devant le véhicule 20, le circuit 33 génère un signal alternatif $S_C$

- en modulation de largeur d'impulsions PWM,

- à une fréquence prédéterminée $\nu = \dfrac{1}{T}$ et

avec un rapport cyclique prédéterminé $\alpha$, conformément au diagramme de la Figure 3B, représentatif de la luminosité de la scène de route devant le véhicule telle que mesurée par le capteur 31.

Ce signal $S_C$ est transmis à l'écran à transmission variable par voie filaire 37 ou au moyen des ondes $O_T$, en tenant compte éventuellement des signaux $L_I$ et $V_C$.

Le coefficient de transmission de l'écran à transmission variable varie, en réponse au signal $S_C$, entre une valeur $CT_{MAX}$ pendant la durée t1 et une valeur (CTmin) pendant la durée $t_2$, avec le même rapport cyclique $\alpha$ que le signal $S_C$ et la même fréquence v.

La valeur $CT_{MAX}$ est celle pour laquelle les verres de lunettes 28 ont leur transparence maximale. Dans la plupart des cas, des écrans à cristaux liquides ou des systèmes microélectromécaniques ont cet état en l'absence de toute excitation électrique, c'est-à-dire à l'état de repos, et ne sont opaques que sous l'effet d'un champ électrique. Dans ces cas, la valeur $CT_{MAX}$ correspond à une excitation minimale des cristaux liquides ou des systèmes microélectromécaniques constituant les verres de lunettes 28.

Dans certains cas, l'état de repos d'un écran à cristaux liquides ou d'un système microélectromécanique pourra être celui où ils présentent leur opacité maximale, ne devenant transparents que sous l'effet d'un champ électrique. Dans cette éventualité, la valeur $CT_{MAX}$ correspond à une excitation maximale des cristaux liquides ou des systèmes microélectromécaniques constituant les verres de lunettes 28.

Les explications qui précèdent s'appliquent, mutatis mutandis, à la valeur $CT_{min}$ du coefficient de transmission des verres de lunettes 28.

Le diagramme de la Figure 3C représente ainsi la variation du coefficient de transmission CT des verres de lunettes 28, et non la variation du signal d'excitation de ces verres de lunettes.

Le conducteur 24 peut donc observer la scène de route SR au travers de l'écran à transmission variable, qu'il s'agisse du pare-brise 26, de l'écran E ou de lunettes 28, dont le coefficient de transmission est ajusté en temps réel en fonction de la luminosité de la scène de route : plus la scène de route est lumineuse, plus l'écran à transmission variable atténue la lumière parvenant au conducteur 24.

L'ajustement automatique du coefficient de transmission de l'écran à transmission variable est obtenu par une succession d'états de transparence maximale et minimale de cet écran, à une fréquence v et avec un rapport cyclique $\alpha$. La fréquence v est choisie suffisamment élevée pour éviter tout phénomène de scintillement pour le conducteur 24 du véhicule 20. La fréquence v sera par exemple supérieure à 100 Hz pour bénéficier à plein du phénomène de persistance rétinienne.

On a donc bien réalisé un dispositif d'aide à la conduite diurne d'un véhicule automobile, qui procure à un conducteur d'un véhicule :

- une atténuation de la luminosité d'une scène de route fortement ensoleillée, évitant ainsi l'éblouissement du conducteur,
- une vision de la scène de route avec une atténuation progressivement décroissante en fonction de la diminution de la luminosité de la scène de route, jusqu'à une transparence maximale pour une luminosité faible de la scène de route,
- la variation de l'atténuation s'effectuant automatiquement et en temps réel, sans que le conducteur soit gêné par ce dispositif, puisque ce dernier est intégré soit dans le pare-brise du véhicule ou dans un écran mobile de type pare-soleil, soit dans une paire de lunettes dont le coefficient de transmission est piloté par une commande sans fil.

Bien entendu, la présente invention n'est pas limitée aux modes de réalisation qui ont été décrits, mais l'homme du métier pourra au contraire lui apporter de nombreuses modifications qui rentrent dans son cadre. C'est ainsi par exemple que l'invention s'applique aussi bien pour les passagers que pour le conducteur, en particulier si l'écran à transmission variable est constitué du pare-brise du véhicule. Si l'écran à transmission variable est constitué de lunettes pour le conducteur comme on l'a plus particulièrement décrit, il est bien clair que le passager pourra également porter des lunettes à coefficient de transmission variable comme celles du conducteur. Si la transmission du signal de commande $S_C$ aux lunettes du conducteur est effectuée par une communication sans fil, les lunettes des passagers recevront le même signal de commande et réagiront comme les lunettes du conducteur, sans aucune adaptation.

De même, on pourra disposer deux écrans à transmission variable successifs, par exemple le pare-brise 26 et un écran mobile E de type pare soleil, pour affecter à la partie supérieure du champ de vision du conducteur (à travers l'écran E et le pare-brise) une atténuation supérieure à celle de la partie inférieure (à travers le pare-brise seul).

On pourra également disposer deux écrans à transmission variable successifs, constitués par le pare-brise 26 et par des lunettes 28 portées par le conducteur. Avec un tel agencement, le conducteur bénéficiera de l'atténuation fixe apportée par le pare-brise cumulée à une atténuation réglable qu'il pourra piloter au tableau de bord, alors que les passagers bénéficieront de l'atténuation fixe apportée par le pare-brise seul.

**Revendications**

1. Procédé d'aide à la conduite diurne d'un véhicule automobile (20), comportant les étapes consistant à :

   - disposer au moins un écran à transmission variable (26, E, 28) entre le conducteur (24) du véhicule et la scène de route (SR) en avant du véhicule (20),

- mesurer à l'aide d'au moins un capteur (31) la luminosité de la scène de route (SR) en avant du véhicule,
- traiter le signal de la mesure de luminosité ($S_L$) pour le transformer en un signal de commande ($S_C$) du coefficient de transmission de l'écran à transmission variable (26, E, 28),

**caractérisé en ce que** le procédé comporte l'étape supplémentaire de transmettre le signal de commande ($S_C$) par des ondes de télécommande ($O_T$) à un récepteur (40) équipant l'écran à transmission variable (26, E, 28) pour moduler le coefficient de transmission (CT) de l'écran à transmission variable (26, E, 28) en fonction de la luminosité mesurée par le capteur (31), et **en ce que** le procédé comporte les étapes supplémentaires consistant à :

- mesurer à l'aide d'un capteur (50) de la quantité de lumière transmise par l'écran à transmission variable,
- recevoir sur une centrale de commande (30) les signaux des capteurs (31, 50),
- effectuer la commande du coefficient de transmission (CT) de l'écran à transmission variable (26, E, 28) à l'aide de ladite centrale de commande (30).

2. Procédé selon la revendication 1, **caractérisé en ce que** le coefficient de transmission (CT) de l'écran à transmission variable (26, E, 28) est modulé en fonction de la luminosité mesurée par le capteur (31), entre une valeur maximale ($CT_{MAX}$) pour une transparence maximale pendant une première durée ($t_1$) et une valeur minimale ($CT_{min}$) pour une transparence minimale pendant une deuxième durée ($t_2$)

3. Procédé selon la revendication 2, **caractérisé en ce que** la première durée ($t_1$) à coefficient de transmission maximale ($CT_{MAX}$) et la deuxième durée ($t_2$) à coefficient de transmission minimale ($CT_{min}$) se succèdent selon un cycle de modulation de largeur d'impulsions PWM.

4. Procédé selon la revendication 3, **caractérisé en ce que** le coefficient de transmission de l'écran à transmission variable (26, E, 28) est fonction de la mesure de la luminosité de la scène de route (SR) en avant du véhicule (20).

5. Dispositif d'aide à la conduite diurne d'un véhicule automobile (20), comportant :

- un écran à transmission variable (26, E, 28) entre le conducteur (24) du véhicule (20) et la scène de route (SR) en avant du véhicule (20),
- un capteur de mesure (31) de la luminosité de la scène de route (SR) en avant du véhicule (20),

- un dispositif de traitement du signal de la mesure de luminosité ($S_L$) pour le transformer en un signal de commande ($S_C$) du coefficient de transmission de l'écran à transmission variable (26, E, 28), **caractérisé en ce que** une centrale de commande (30) reçoit le signal de commande ($S_C$) et le transmet par ondes de télécommande ($O_T$) à un récepteur (40) équipant l'écran à transmission variable (26, F, 28) pour en piloter le coefficient de transmission (CT), et **en ce que** le dispositif comporte également d'un capteur (50) de mesure de la quantité de lumière transmise par l'écran à transmission variable et **en ce que** la centrale de commande (30) reçoit les signaux dudit capteur (50) de mesure de la quantité de lumière transmise par l'écran à transmission variable.

6. Dispositif selon la revendication précédente, **caractérisé en ce que** le coefficient de transmission (CT) de l'écran à transmission variable (26, F, 28) est modulé, en fonction de la luminosité mesurée par le capteur (31), entre une valeur maximale ($CT_{MAX}$) pour une transparence maximale pendant une première durée ($t_1$) et une valeur minimale ($CT_{min}$) pour une transparence minimale pendant une deuxième durée ($t_2$)

7. Dispositif selon la revendication précédente, **caractérisé en ce que** le coefficient de transmission (CT) de l'écran à transmission variable (26, E, 28) est modulé selon un cycle de modulation de largeur d'impulsions PWM.

8. Dispositif selon la revendication précédente, **caractérisé en ce que** le rapport cyclique ($\alpha$) du cycle de modulation de largeur d'impulsions PWM est fonction de la mesure de la luminosité de la scène de route (SR) en avant du véhicule (20) .

9. Dispositif selon l'une quelconque des revendications 5 à 8, **caractérisé en ce que** l'écran à transmission variable entre le conducteur (24) du véhicule (20) et la scène de route (SR) en avant du véhicule (20) est constitué par :

- le pare-brise (26) du véhicule (20),
- un écran (E) disposé entre le pare-brise (26) du véhicule (20) et le conducteur (24) du véhicule (20), ou
- des lunettes (28) portées par le conducteur (24) du véhicule (20).

10. Dispositif selon l'une quelconque des revendications 5 à 9, **caractérisé en ce que** la commande du coefficient de transmission (CT) de l'écran à transmission variable (26, E, 28) en fonction de la luminosité mesurée est effectuée selon un protocole de communication sans fil.

11. Dispositif selon l'une des revendications précédentes, **caractérisé en ce que** l'écran à transmission variable (26, F, 28) est constitué d'un écran à cristaux liquides ou d'un système microélectromécanique.

12. Dispositif selon l'une des revendications précédentes, **caractérisé en ce que** l'écran à transmission variable (26, F, 28) est associé à une alimentation électrique autonome.

13. Ecran à transmission variable (26, F, 28) apte à être disposé entre le conducteur (24) d'un véhicule automobile (20) et la scène de route (SR) en avant du véhicule (20), caractérisé en que le coefficient de transmission (CT) de l'écran (26, F, 28) est variable selon un mode de Modulation de Largeur d'Impulsions (PWM) entre une valeur maximale ($CT_{MAX}$) et une valeur minimale ($CT_{min}$), le coefficient de transmission (CT) de l'écran à transmission variable (26, F, 28) étant piloté par une centrale de commande (30) selon un protocole de communication sans fil, par des ondes de télécommande (OT) émises par un émetteur de la centrale de commande (30) et reçues par un récepteur (40), et en ce que ladite centrale de commande (30), reçoit les signaux d'un capteur (31) de mesure de la luminosité de la scène de route en avant du véhicule, et les signaux d'un capteur (50) de mesure de la quantité de lumière transmise par l'écran à transmission variable.

**Patentansprüche**

1. Verfahren zur Unterstützung beim Fahren eines Kraftfahrzeugs (20) bei Tag, das die folgenden Schritte umfasst:

- Anordnen mindestens einer Abschirmung mit variabler Transmission (26, E, 28) zwischen dem Fahrer (24) des Fahrzeugs und der Straßenszene (SR) vor dem Fahrzeug (20),
- Messen der Helligkeit der Straßenszene (SR) vor dem Fahrzeug mithilfe mindestens eines Sensors (31),
- Verarbeiten des Signals der Helligkeitsmessung ($S_L$), um es in ein Steuersignal ($S_C$) zum Steuern des Transmissionskoeffizienten der Abschirmung mit variabler Transmission (26, E, 28) umzuwandeln,

**dadurch gekennzeichnet, dass** das Verfahren den zusätzlichen Schritt des Übertragens des Steuersignals ($S_C$) über Fernsteuerungswellen ($O_T$) an einen Empfänger (40), mit dem die Abschirmung mit variabler Transmission (26, E, 28) ausgestattet ist, umfasst, um den Transmissionskoeffizienten (CT) der Abschirmung mit variabler Transmission (26, E, 28) in Abhängigkeit von der vom Sensor (31) gemessenen Helligkeit zu modulieren, und dadurch, dass das Verfahren die folgenden zusätzlichen Schritte umfasst:

- Messen der von der Abschirmung mit variabler Transmission durchgelassenen Lichtmenge mithilfe eines Sensors (50),
- Empfangen der Signale der Sensoren (31, 50) an einer Steuerzentrale (30),
- Durchführen des Steuerns des Transmissionskoeffizienten (CT) der Abschirmung mit variabler Transmission (26, E, 28) mithilfe der Steuerzentrale (30).

2. Verfahren nach Anspruch 1, **dadurch gekennzeichnet, dass** der Transmissionskoeffizient (CT) der Abschirmung mit variabler Transmission (26, E, 28) in Abhängigkeit von der vom Sensor (31) gemessenen Helligkeit zwischen einem Höchstwert ($CT_{MAX}$) für eine maximale Transparenz während einer ersten Dauer ($t_1$) und einem Mindestwert ($CT_{min}$) für eine minimale Transparenz während einer zweiten Dauer ($t_2$) moduliert wird.

3. Verfahren nach Anspruch 2, **dadurch gekennzeichnet, dass** die erste Dauer ($t_1$) mit maximalem Transmissionskoeffizienten ($CT_{MAX}$) und die zweite Dauer ($t_2$) mit minimalem Transmissionskoeffizienten ($CT_{min}$) gemäß einem Pulsweitenmodulationszyklus PWM aufeinander folgen.

4. Verfahren nach Anspruch 3, **dadurch gekennzeichnet, dass** der Transmissionskoeffizient der Abschirmung mit variabler Transmission (26, E, 28) von der Messung der Helligkeit der Straßenszene (SR) vor dem Fahrzeug (20) abhängig ist.

5. Vorrichtung zur Unterstützung beim Fahren eines Kraftfahrzeugs (20) bei Tag, umfassend:

- eine Abschirmung mit variabler Transmission (26, E, 28) zwischen dem Fahrer (24) des Fahrzeugs (20) und der Straßenszene (SR) vor dem Fahrzeug (20),
- einen Sensor (31) zum Messen der Helligkeit der Straßenszene (SR) vor dem Fahrzeug (20),
- eine Vorrichtung zur Verarbeitung des Signals der Helligkeitsmessung ($S_L$), um es in ein Steuersignal ($S_C$) zum Steuern des Transmissionskoeffizienten der Abschirmung mit variabler Transmission (26, E, 28) umzuwandeln,

**dadurch gekennzeichnet, dass** eine Steuerzentrale (30) das Steuersignal ($S_C$) empfängt und es über Fernsteuerungswellen ($O_T$) an einen Empfänger (40) überträgt, mit dem die Abschirmung mit variabler Transmission (26, F, 28) ausgestattet ist, um deren Transmissionskoeffizienten (CT) zu steuern, und dass die Vorrichtung auch einen Sensor (50) zum Messen der durch die Abschirmung mit variabler Transmission durchgelassenen Lichtmenge umfasst und dass die Steuerzentrale (30) die Signale des Sensors (50) zum Messen der von der Abschirmung mit variabler Transmission durchgelassenen Lichtmenge empfängt.

6. Vorrichtung nach dem vorhergehenden Anspruch, **dadurch gekennzeichnet, dass** der Transmissionskoeffizient (CT) der Abschirmung mit variabler Transmission (26, F, 28) in Abhängigkeit von der vom Sensor (31) gemessenen Helligkeit zwischen einem Höchstwert ($CT_{MAX}$) für eine maximale Transparenz während einer ersten Dauer ($t_1$) und einem Mindestwert ($CT_{min}$) für eine minimale Transparenz während einer zweiten Dauer ($t_2$) moduliert wird.

7. Vorrichtung nach dem vorhergehenden Anspruch, **dadurch gekennzeichnet, dass** der Transmissionskoeffizient (CT) der Abschirmung mit variabler Transmission (26, E, 28) nach einem Pulsweitenmodulationszyklus PWM moduliert wird.

8. Vorrichtung nach dem vorhergehenden Anspruch, **dadurch gekennzeichnet, dass** das Tastverhältnis ($\alpha$) des Pulsweitenmodulationszyklus PWM von der Messung der Helligkeit der Straßenszene (SR) vor dem Fahrzeug (20) abhängig ist.

9. Vorrichtung nach einem der Ansprüche 5 bis 8, **dadurch gekennzeichnet, dass** die Abschirmung mit variabler Transmission zwischen dem Fahrer (24) des Fahrzeugs (20) und der Straßenszene (SR) vor dem Fahrzeug (20) aus Folgendem besteht:

   - der Windschutzscheibe (26) des Fahrzeugs (20),
   - einer Abschirmung (E), die zwischen der Windschutzscheibe (26) des Fahrzeugs (20) und dem Fahrer (24) des Fahrzeugs (20) angeordnet ist, oder
   - einer Brille (28), die vom Fahrer (24) des Fahrzeugs (20) getragen wird.

10. Vorrichtung nach einem der Ansprüche 5 bis 9, **dadurch gekennzeichnet, dass** das Steuern des Transmissionskoeffizienten (CT) der Abschirmung mit variabler Transmission (26, E, 28) in Abhängigkeit von der gemessenen Helligkeit nach einem Drahtlos-Kommunikationsprotokoll durchgeführt wird.

11. Vorrichtung nach einem der vorhergehenden Ansprüche, **dadurch gekennzeichnet, dass** die Abschirmung mit variabler Transmission (26, F, 28) aus einem Flüssigkristallbildschirm oder einem mikroelektromechanischen System besteht.

12. Vorrichtung nach einem der vorhergehenden Ansprüche, **dadurch gekennzeichnet, dass** die Abschirmung mit variabler Transmission (26, F, 28) einer autonomen Stromversorgung zugeordnet ist.

13. Abschirmung mit variabler Transmission (26, F, 28), die geeignet ist, zwischen dem Fahrer (24) eines Kraftfahrzeugs (20) und der Straßenszene (SR) vor dem Fahrzeug (20) angeordnet zu werden, **dadurch gekennzeichnet, dass** der Transmissionskoeffizient (CT) der Abschirmung (26, F, 28) nach einem Pulsweitenmodulationsmodus (PWM) zwischen einem Höchstwert ($CT_{MAX}$) und einem Mindestwert ($CT_{min}$) variabel ist, wobei der Transmissionskoeffizient (CT) der Abschirmung mit variabler Transmission (26, F, 28) von einer Steuerzentrale (30) nach einem Drahtlos-Kommunikationsprotokoll über Fernsteuerungswellen ($O_T$) gesteuert wird, die von einem Sender der Steuerzentrale (30) gesendet und von einem Empfänger (40) empfangen werden, und dass die Steuerzentrale (30) die Signale eines Sensors (31) zum Messen der Helligkeit der Straßenszene vor dem Fahrzeug und die Signale eines Sensors (50) zum Messen der von der Abschirmung mit variabler Transmission durchgelassenen Lichtmenge empfängt.

**Claims**

1. Method for assisting the daytime driving of a motor vehicle (20), including the steps of:

   - placing at least one variable-transmission screen (26, E, 28) between the driver (24) of the vehicle and the road scene (SR) in front of the vehicle (20),
   - measuring, by means of at least one sensor (31), the brightness of the road scene (SR) in front of the vehicle,
   - processing the brightness measurement signal ($S_L$) to convert it into a signal ($S_C$) for controlling the coefficient of transmission of the variable-transmission screen (26, E, 28),

   **characterized in that** the method includes the further step of transmitting the control signal ($S_C$) by remote control waves ($O_T$) to a receiver (40) fitted to the variable-transmission screen (26, E, 28) for modulating the coefficient of transmission (CT) of the variable-transmission screen (26, E, 28) as a function of the brightness measured by the sensor (31), and **in that** the method includes further steps in which:

- the amount of light transmitted by the variable-transmission screen is measured by means of a sensor (50),
- the signals of the sensors (31, 50) are received by a control unit (30),
- the transmission coefficient (CT) of the variable-transmission screen (26, E, 28) is controlled by means of said control unit (30).

2. Method according to Claim 1, **characterized in that** the coefficient of transmission (CT) of the variable-transmission screen (26, E, 28) is modulated as a function of the brightness measured by the sensor (31), between a maximum value ($CT_{MAX}$) for a maximum transparency for a first duration ($t_1$) and a minimum value ($CT_{min}$) for a minimum transparency for a second duration ($t_2$).

3. Method according to Claim 2, **characterized in that** the first duration ($t_1$) with a maximum coefficient of transmission ($CT_{MAX}$) and the second duration ($t_2$) with a minimum coefficient of transmission ($CT_{min}$) follow one another according to a pulse width modulation (PWM) cycle.

4. Method according to Claim 3, **characterized in that** the coefficient of transmission of the variable-transmission screen (26, E, 28) is a function of the measurement of the brightness of the road scene (SR) in front of the vehicle (20).

5. Device for assisting the daytime driving of a motor vehicle (20), including:

    - a variable-transmission screen (26, E, 28) between the driver (24) of the vehicle (20) and the road scene (SR) in front of the vehicle (20),
    - a sensor (31) which measures the brightness of the road scene (SR) in front of the vehicle (20),
    - a device for processing the brightness measurement signal ($S_L$) to convert it into a signal ($S_C$) for controlling the coefficient of transmission of the variable-transmission screen (26, E, 28),

    **characterized in that** a control unit (30) receives the control signal ($S_C$) and transmits it by remote control waves ($O_T$) to a receiver (40) fitted to the variable-transmission screen (26, F, 28) in order to control the coefficient of transmission (CT) and **in that** the device also includes a sensor (50) for measuring the amount of light transmitted by the variable-transmission screen and **in that** the control unit (30) receives the signals from said sensor (50) for measuring the amount of light transmitted by the variable-transmission screen.

6. Device according to the preceding claim, **characterized in that** the coefficient of transmission (CT) of the variable-transmission screen (26, F, 28) is modulated as a function of the brightness measured by the sensor (31), between a maximum value ($CT_{MAX}$) for a maximum transparency for a first duration ($t_1$) and a minimum value ($CT_{min}$) for a minimum transparency for a second duration ($t_2$).

7. Device according to the preceding claim, **characterized in that** the coefficient of transmission (CT) of the variable-transmission screen (26, E, 28) is modulated according to a pulse width modulation (PWM) cycle.

8. Device according to the preceding claim, **characterized in that** the duty cycle ($\alpha$) of the pulse width modulation (PWM) cycle is a function of the measurement of the brightness of the road scene (SR) in front of the vehicle (20).

9. Device according to any of Claims 5 to 8, **characterized in that** the variable-transmission screen between the driver (24) of the vehicle (20) and the road scene (SR) in front of the vehicle (20) is formed by:

    - the windshield (26) of the vehicle (20),
    - a screen (E) placed between the windshield (26) of the vehicle (20) and the driver (24) of the vehicle (20), or
    - glasses (28) worn by the driver (24) of the vehicle (20).

10. Device according to any of Claims 5 to 9, **characterized in that** the coefficient of transmission (CT) of the variable-transmission screen (26, E, 28) is controlled as a function of the measured brightness according to a wireless communication protocol.

11. Device according to one of the preceding claims, **characterized in that** the variable-transmission screen (26, F, 28) is formed by a liquid crystal screen or by a microelectromechanical system.

12. Device according to one of the preceding claims, **characterized in that** the variable-transmission screen (26, F, 28) is associated with an independent electrical power supply.

13. Variable-transmission screen (26, F, 28) adapted to be placed between the driver (24) of a motor vehicle (20) and the road scene (SR) in front of the vehicle (20), **characterized in that** the coefficient of transmission (CT) of the screen (26, F, 28) is variable according to a pulse width modulation (PWM) mode between a maximum value ($CT_{MAX}$) and a minimum value ($CT_{min}$), the coefficient of transmission (CT) of the variable-transmission screen (26, F, 28) being controlled by a control unit (30) according to a wireless communication protocol, by means of remote control waves (OT) transmitted by a transmitter of the control unit (30) and received by a receiver (40), and **in that** said control unit (30) receives the signals from a sensor (31) for measuring the brightness of the road scene in front of the vehicle, and the signals from a sensor (50) for measuring the amount of light transmitted by the variable-transmission screen.

**Fig. 1**

EP 2 830 899 B1

**Fig. 2**

SR

26, E, 28

31

$S_L$

33

$S_C$

37

30

$V_C$

54

$O_T$

40

50

24

$L_I$

52

EP 2 830 899 B1

**Fig. 3A**

**Fig. 3B**

**Fig. 3C**

## RÉFÉRENCES CITÉES DANS LA DESCRIPTION

**Documents brevets cités dans la description**

- US 3961181 A
- US 4848890 A
- EP 0498143 A
- US 4286308 A
- WO 9620846 A
- US 7684105 B